(19)

Europäisches
Patentamt
European
Patent Office
Office européen
des brevets

(11)     **EP 1 239 603 B1**

(12)                    **EUROPEAN PATENT SPECIFICATION**

(45) Date of publication and mention
of the grant of the patent:
**23.06.2010   Bulletin 2010/25**

(51) Int Cl.:
*H04W 52/52* (2009.01)

(21) Application number: **01400637.3**

(22) Date of filing: **09.03.2001**

(54) **Power amplifier driver and method of using it**

Treiber für Leistungsverstärker und Betriebsverfahren

Circuit d'excitation d'un amplificateur de puissance et procédé d'utilisation

(84) Designated Contracting States:
**DE FI FR**

(43) Date of publication of application:
**11.09.2002   Bulletin 2002/37**

(73) Proprietor: **Semiconductor Components
Industries, LLC
Phoenix,
Arizona 85008 (US)**

(72) Inventor: **Genest, Pierre
31180 Rouffiac Tolosan (FR)**

(74) Representative: **Hirsz, Christopher Stanislaw et al
HLBBshaw
Merlin House
Falconry Court
Baker's Lane
Epping, Essex CM16 5DQ (GB)**

(56) References cited:
**US-A- 5 150 075     US-A- 5 448 770**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Background of the Invention

The present invention relates in general to power amplifier drivers and, more particularly, to power amplifier drivers for use in wireless circuitry exhibiting high bandwidth at low power consumption.

In most modern radio transmitters, the transmitted signal amplitude needs to be accurately controlled to cope with existing standards. Due to manufacturing and environment variations, it is very difficult to control the amplifier's output power without any feedback, therefore, feedback is generally used to provide transmitted power control. The feedback may be realized by measuring the output power or any other parameter reflecting the output power level. The measured value is compared to a reference level and an error correction is subsequently applied to the gain control of the power amplifier to adjust the transmitted signal amplitude. The negative feedback loop allows an accurate power control as long as the measurement device and the comparison device are accurate too. Furthermore, a high gain should exist to ensure that the measurement result is actually very close to the reference, but low enough such that the control loop maintains stability.

In actual implementation, a power detector, connected to the power amplifier output through a directional coupler often realizes the power measurement. A differential amplifier realizes the signal comparison and provides the requested high gain. The implementation is not sufficient, however, to insure stability. The power amplifier, the detector and the differential amplifier are introducing cutoff frequencies and phase shifts, which could cause the system to become unstable. Since it is very difficult to remove cutoff frequencies introduced by the power amplifier, detector and signal comparator, an efficient solution is to create a dominant pole which gives the loop a first order behavior. The first order behavior is implemented using a low pass filter or by using an integrator to simultaneously create a very high open-loop gain and a dominant low frequency pole. The filter or integrator is commonly realized using operational amplifiers.

In Time Division Multiple Access (TDMA) systems, the Radio Frequency (RF) designer is tasked with another problem. In order to limit spurious, out-of-band frequency transmission, output power transitions from low power to high power and high power to low power should be controlled, or smoothed, to limit spurious transmissions. In the transmission timeslot, the output power is at a normal operating level, however, out of the transmission timeslot, the power level should be decreased to a very low output level. Operation of the power amplifier control loop just prior to the transmission timeslot is open loop, since the control input is tied to ground potential and no output signal is transmitted. At the beginning of the transmission timeslot, the loop must be closed in a relatively short amount of time which may cause initial instability within the control loop resulting in unwanted oscillation. A simple solution is to add a fixed voltage before the transmission time slot to allow the system to quickly close the loop at the beginning of the ramp. The fixed voltage can be implemented with an operational amplifier or an acquisition device, which senses the power amplifier emission threshold. Some prior art solutions add another pole to the control loop when the acquisition circuitry is added, subsequently requiring the operational amplifier to have a higher cutoff frequency to maintain an acceptable phase margin. Other prior art solutions do not add a pole to the loop, but the automated operation of the prior art solutions are relatively complicated and limit flexibility to the RF designer. In US Patent No. 5,150,075 there is disclosed a power amplifier controller which powers up a power amplifier without a substantial burst of frequency noise. The controller has a RF output power detector (211) which generates a signal correlated to the power level of the power amplifier. This signal is compared to a reference signal to determine if the power amplifier is active. The signal generated by this comparator is used to determine the voltage level of the Automatic Output Control (AOC) signal. In US Patent No. 5,448,770 there is disclosed a TC controlled RF signal detecting circuitry used in the output power control circuit of a TDMA RF signal power amplifier including a positive coefficient current source producing current I+ having a positive TC, a negative coefficient current source producing current I- having a negative TC, and current mirror for summing currents I+ and I- to produce substantially identical compensated mirror currents.

Hence, there is a need for a power amplifier driver and associated control loop which provides adequate stability and dynamic range with adequate performance both in and out of the transmission timeslot.

Brief Description of the Drawings

FIG. 1 is a block diagram illustrating a Time Division Multiple Access transmission system;
FIG. 2 is a schematic diagram illustrating the power amplifier driver of FIG. 1;
FIG. 3 is a schematic diagram illustrating the power detector of FIG. 2;
FIG. 4 is a schematic diagram illustrating the integrator of FIG. 2;
FIG. 5 is a schematic diagram of the PMOS current mirror of FIG. 4;
FIG. 6 is a schematic diagram of the NMOS current mirror of FIG. 4; and
FIG. 7 is a schematic diagram illustrating the minimum voltage adder of FIG. 2.

Detailed Description of the Drawings

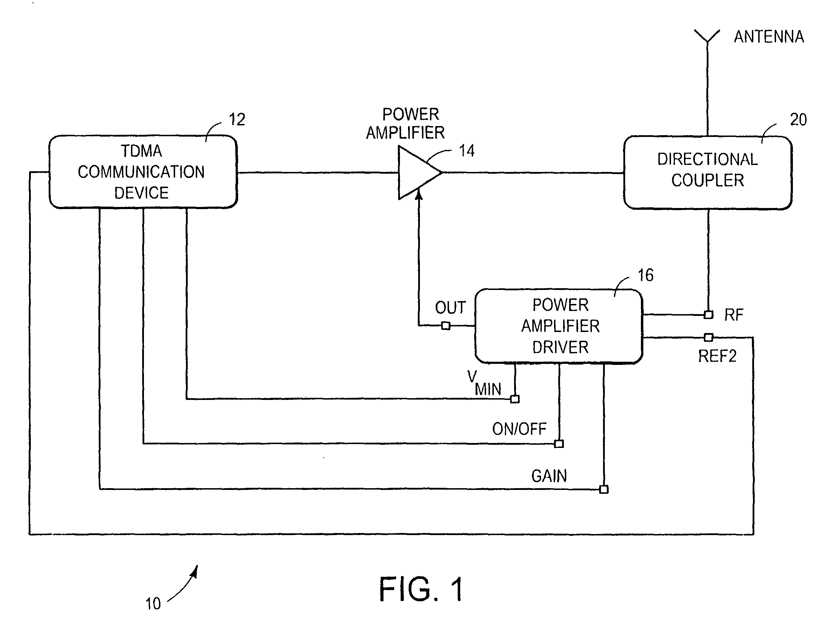

In FIG. 1, a TDMA transmission system 10 is illustrated. The TDMA communication device 12 generates a radio frequency (RF) signal and delivers the RF signal to power amplifier 14, which is subsequently provided to directional coupler 20. Directional coupler 20 provides both an RF signal to the antenna for long distance propagation and an RF signal to terminal RF for feedback information. The amplitude of the power provided to terminal RF is generally on the order of 30-40 dB lower than the power provided to the antenna. In other words, the power provided to terminal RF is 1000 to 10,000 times lower than the power provided to the antenna. A feedback path, therefore, exists from the antenna input to the gain control pin, OUT, of power amplifier 14 via directional coupler 20 and power amplifier driver 16. The signal delivered to the antenna is monitored by power amplifier driver 16 and a gain control signal is delivered to power amplifier 14 via the OUT terminal, constituting feedback to control the output power level of power amplifier 14. Several control signals are delivered by TDMA communication device 12 to power amplifier driver 16 via the $V_{min}$, ON/OFF, GAIN and REF2 terminals explained hereinafter. Power amplifier driver 16 may be implemented as an integrated circuit, whereby the coupled RF signal is provided as feedback to pin RF via directional coupler 20, and the control voltage responsible for controlling the output power of power amplifier 14 is provided by pin OUT.

TDMA specifications mandate that communication functions occur at specific time intervals. The time intervals are generally several microseconds in duration, for example 577 micro-seconds ($\mu$s), and are repetitive, such that 8 separate time slots exist within a first data frame before the time slots repeat in subsequent data frames. One timeslot is generally allocated for transmission, one timeslot for reception and the remaining time slots allocated for overhead functions. TDMA communication device 12 must, therefore, provide control signal ON/OFF to power amplifier driver 16 so that power amplifier 14 is on during the transmission timeslot and off during the remaining 7 timeslots. ON/OFF control is required to keep spurious transmissions, during the remaining 7 timeslots, below a maximum level threshold. TDMA communication device 12 provides $V_{min}$ to power amplifier driver 16, which subsequently provides a power amplifier control voltage at terminal OUT such that power amplifier 14 is transmitting at just below the maximum output power allowable, $P_{IDLE}$, just prior to the transmission timeslot or idle period. $V_{min}$, therefore, is said to place a bias on the gain control input to power amplifier 14, such that the output power level of power amplifier 14 is precisely at $P_{IDLE}$, during idle or non-transmission timeslots.

Power amplifier 14 exhibits non-linear power output versus input control voltage. The non-linear operation of power amplifier 14 presents a difficult problem of non-linear stability over the full range of output power for power amplifier 14. Terminal GAIN provides a programming terminal with which the closed loop stability of TDMA transmission system 10 is controlled. Terminal REF2 provides a method whereby TDMA communication device 12 can program the output power of power amplifier 14, during non-idle, or transmission timeslots.

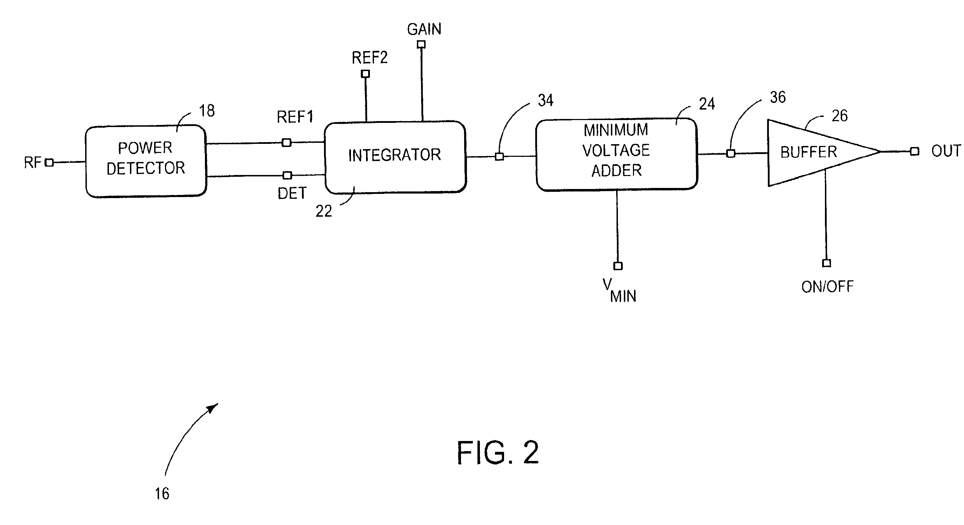

FIG. 2 illustrates the block diagram representation of power amplifier driver 16. Power detector 18 receives the RF feedback signal at terminal RF, which is representative of the RF signal sent to the antenna. Power detector 18 provides a detected power level at node DET and a reference level at node REF1 to integrator 22. The REF2 and GAIN terminals are coupled to integrator 22 to allow for output power control and loop stability performance control, respectively. Integrator 22 provides the integrated error signal at node 34 to minimum voltage adder 24. Minimum voltage adder 24 is coupled to receive an offset voltage at terminal $V_{min}$. $V_{min}$ represents the voltage required to maintain a minimum operating output power level of power amplifier 14 resulting in a transmitted power level which is just below the maximum allowable transmitted power level, $P_{IDLE}$, during idle timeslots. Buffer 26 provides a unity gain driver coupled to terminal OUT and also receives the ON/OFF control signal from TDMA communication device 12. Buffer 26 is implemented to provide sufficient current drive as required by power amplifier 14 during all timeslots. Control input from terminal ON/OFF allows the voltage at terminal OUT to correct the feedback control loop error signal developed by directional coupler 20 and power amplifier driver 16 when in the "on" state. Control input from terminal ON/OFF allows the control voltage at terminal OUT to effectively set the output power level of power amplifier 14 to zero when in the "off" state.

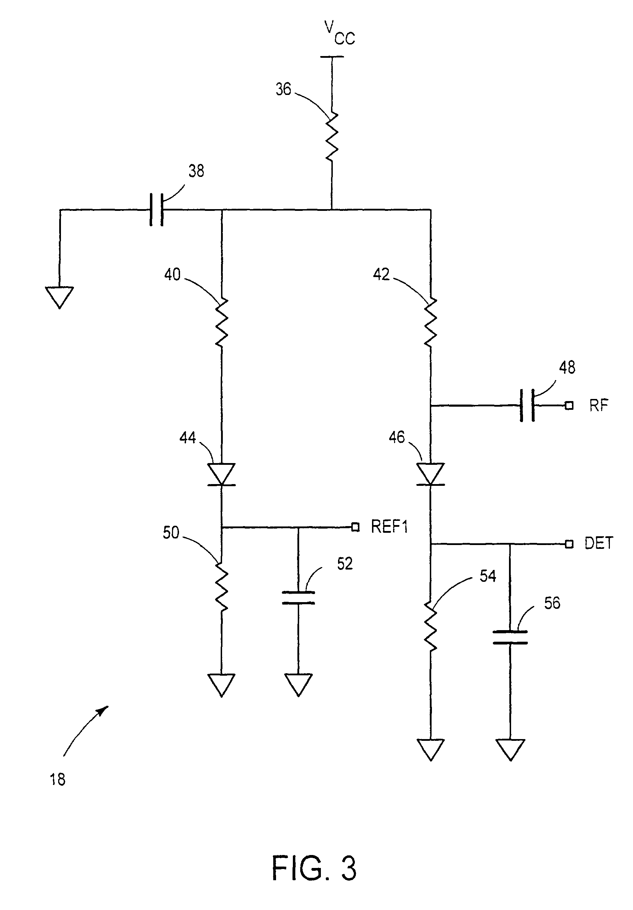

FIG. 3 illustrates a detailed schematic of power detector 18. Node RF is coupled to receive the feedback signal, which is representative of the RF signal sent to the antenna for long distance transmission, at a first terminal of capacitor 48. A second terminal of capacitor 48 is coupled to a first terminal of resistor 42 and the anode of diode 46. The cathode of diode 46 is coupled to first terminals of resistor 54 and capacitor 56 at node DET. Second terminals of resistor 54 and capacitor 56 are coupled to a first power supply potential, for example, ground potential. A second terminal of resistor 42 is coupled to first terminals of resistor 36, resistor 40 and capacitor 38. A second terminal of resistor 36 is coupled to a second power supply potential, $V_{cc}$. A second terminal of capacitor 38 is coupled to the first power supply potential, for example, ground potential. A second terminal of resistor 40 is coupled to the anode of diode 44. The cathode of diode 44 is coupled to first terminals of resistor 50 and capacitor 52 at node REF1. Second terminals of resistor 50 and capacitor 52 are coupled to the first power supply potential, for example, ground potential. Power detector 18 comprises a two stage detection circuit. The first stage comprising diode 46, resistor 54 and capacitor 56 and the second stage comprising diode 44, resistor 50 and capacitor 52. As is known, diodes 44 and 46 are implemented either using diode devices or transistors connected as diodes. A Field Effect Transistor (FET), for example, is diode connected by coupling the gate electrode to the drain electrode to form the anode of an equivalent diode.

In operation, power detector 18 receives an RF signal at node RF and performs amplitude demodulation of the RF signal. Capacitor 48 provides Alternating Current (AC) coupling to node RF such that no Direct Current (DC) content is allowed to be introduced into power detector 18. Diode 46 provides half wave rectification of the input signal present at node RF, thus providing peak detection, or amplitude detection, of the input signal. Resistor 54 and capacitor 56 combine to form an RC filter which acts to smooth the amplitude detection signal conducted by diode 46. A top rail power supply is coupled to node $V_{cc}$ which acts to properly forward bias diodes 46 and 44. A DC signal, or bias signal, therefore exists at nodes DET and REF1, as a result of the bias signal applied to diodes 46 and 44. Resistor pair 40 and 42, diode pair 44 and 46 and RC filter pair 50,52 and 54,56 are matched, such that the bias signal present at node REF1 is substantially equivalent to the bias signal present at node DET, in the absence of an RF signal present at node RF. In the absence of an RF signal present at node RF, therefore, the signal present at nodes DET and REF1 is characterized by $V_{bias} = V_{cc}-I_d$ $(R_{36}+R_{42})-V_{46}$. where $I_{46}$ is the current conducted by diode 46, $R_{36}$ is the resistance value of resistor 36, $R_{42}$ is the resistance value of resistor 42 and $V_{46}$ is the voltage drop across diode 46 when diode 46 is forward biased. Since the paired components mentioned earlier are matched, $V_{bias}$ is substantially equivalent at nodes DET and REF1 in the absence of an RF signal present at node RF. In the presence of an RF signal present at node RF, node DET contains two signal components, $V_{bias}$ and $V_{det}$, whereas node REF1 contains only the single component, $V_{bias}$. $V_{det}$ is the smoothed, amplitude detection signal produced by diode 46, in combination with resistor 54 and capacitor 56, which is the representation of the peak RF signal present at node RF. Power detector 18, therefore, provides an accurate power detection signal representative of the power level present at terminal RF, by providing a differential output signal at terminals DET and REF1. The differential output signal at terminals DET and REF1 contain a common mode signal equal to $V_{bias}$, which can be effectively removed by a differential amplifier, to provide a substantially error free detected output power level signal, $V_{det}$, at the output of the differential amplifier.

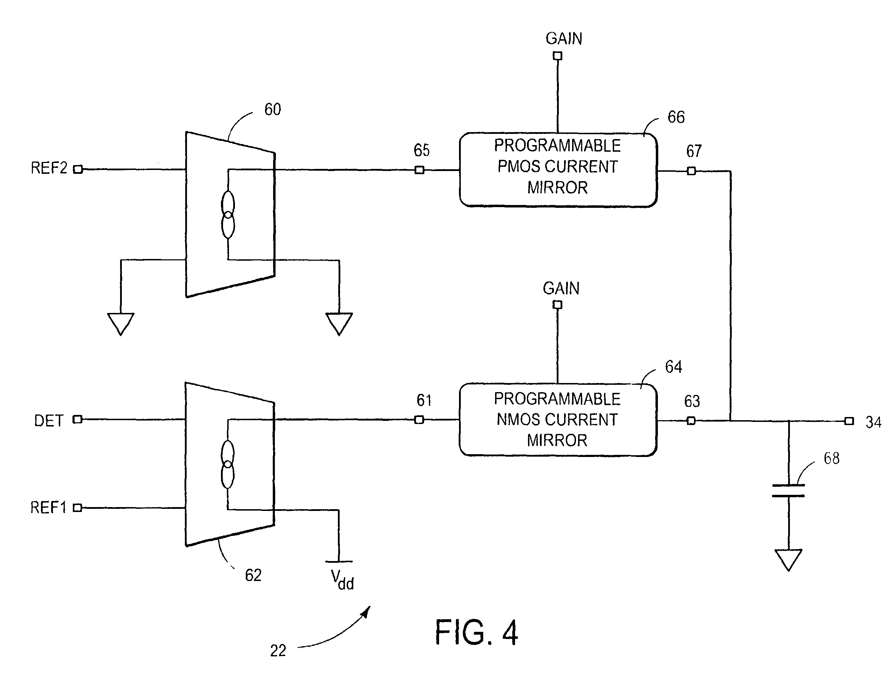

FIG. 4 illustrates a block diagram representation of integrator 22 as shown in FIG. 2. Integrator 22 comprises transconductance differential amplifiers 60 and 62. Transconductance differential amplifier 62 receives the detected amplitude of the input signal, $V_{det}$, as received at node RF from power detector 18 at node DET. Transconductance amplifier 62 also receives the common mode signal from power detector 18 at node REF1, $V_{bias}$. The common mode signal received at node REF1, as discussed earlier, is the DC bias signal produced by power detector 18 with no RF signal present at node RF. Transconductance differential amplifier 60 receives a second reference signal, REF2, produced by TDMA communication device 12.

Programmable current mirrors 64 and 66 are coupled to receive the output of transconductance amplifiers 62 and 60, respectively. Programmable current mirrors 64 and 66 are coupled to node GAIN, which is under the control of TDMA communication device 12. The first conductor of capacitor 68 is coupled to the output of programmable current mirrors 64 and 66 and to the output of integrator 22 at node 34. The second conductor of capacitor 68 is coupled to the first power supply potential, for example, ground potential.

In operation, integrator 22 performs two functions. First, integrator 22 is responsible for producing the difference signal, $V_{diff}$, which is the difference voltage between the common mode voltage, $V_{bias}$, at node REF1 and the detection voltage, $V_{det}$, at node DET, where $V_{diff} = V_{det}-V_{bias}$. The operation of transconductance amplifier 62 is to perform the voltage difference measurement and deliver the result in the form of a current. It can be said, therefore, that amplifier 62 performs in a current mode of operation to provide the voltage difference signal at node 61 in the form of a current signal. The transconductance of transconductance amplifier 62 is given by $g_{m62} = 1/R = I_{62}/V_{diff}$. In other words, the output of transconductance amplifier 62 is a current signal, $I_{62}$, which is a function of the difference voltage between $V_{det}$ and $V_{bias}$, or $V_{diff}$. The transconductance of transconductance amplifier 60 is given by $g_{m60} = 1/R = I_{60}/V_{REF2}$. The second input to transconductance amplifier 60 is coupled to ground potential, therefore, the output current of transconductance amplifier 60, $I_{60}$, is referenced to the input voltage present at node REF2. Programmable current mirrors 64 and 66 provide currents at nodes 63 and 67, respectively, according to the current ratio setup within each current mirror. The amount of current delivered to node 67 is equal to $I_{67}=I_{65}*Ratio$ plus the effect of the GAIN signal described herein. The amount of current delivered to node 63 is $I_{63}=I_{62}*Ratio$ plus the effect of the GAIN signal described herein.

The second function of integrator 22 is to provide the operating bandwidth of the power control loop established by power amplifier driver 16. By establishing the correct operating bandwidth of the power control loop, system stability is guaranteed. An important feature of integrator 22 is the minimization of the error signal resulting from the comparison of $V_{bias}$ and $V_{det}$ by transconductance amplifier 62, due to the high gain exhibited by transconductance amplifier 62. As a result, power control accuracy is enhanced with minimal sacrifice to stability.

The output current at node 34 serves to charge capacitor 68, thereby providing an error voltage across capacitor 68. The GAIN term represents the binary signal provided by TDMA communication device 12, which allows programming of programmable current mirrors 64 and 66, to change the output current mirror ratio from one ratio to a second ratio. Changing the output current mirror ratio allows modification of the control loop bandwidth without modification of passive device 68. Increasing the current ratio, for example, serves to increase the BW of the control loop providing faster loop operation. Allowing modification of the control loop bandwidth through the GAIN terminal is an important feature of integrator 22. Modification of the control bandwidth can be achieved without causing voltage glitches at the control terminal of power amplifier 14. Current glitches due to the modification of the output current mirror ratio are possible, however, but the current glitches will be integrated and will create a short slope variation at the control terminal of power amplifier 14. It should be noted that PMOS current mirror 66 sources current into capacitor 68 and NMOS current mirror 64 sinks current from capacitor 68 to control the error voltage generated at node 34.

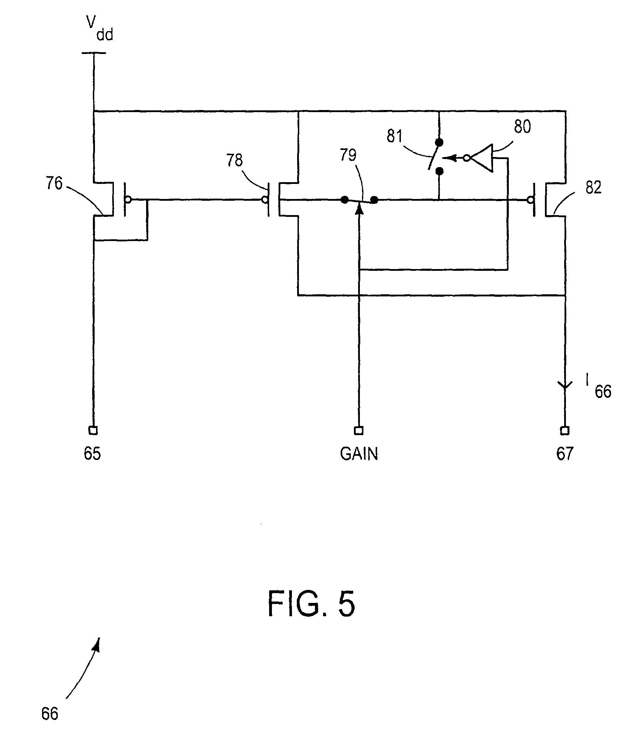

FIG. 5 illustrates a schematic diagram of PMOS current mirror 66. The gate terminals of PMOS transistors 76, 78 and a first conductor of switch 79 are coupled to a first conductor of transistor 76 at node 65. A second conductor of switch 79 is coupled to a first conductor of switch 81 and the gate terminal of transistor 82. The GAIN node is coupled to the control terminal of switch 79 and to the input to inverter 80. A first conductor of transistors 78 and 82 are coupled together at node 67 to provide the output current, $I_{66}$, of PMOS current mirror 66.

In operation, PMOS current mirror 66 receives an input current at node 65 from transconductance amplifier 60. A low gain condition is set when GAIN is at a logic low, rendering switch 81 in a closed position and switch 79 in an open position. Transistor 82 is rendered non-conductive, therefore, $I_{66}$ is a mirrored current generated by transistor 78 in relation to the ratio of geometries between transistor 78 to transistor 76. In other words, if the geometries of transistor 78 and transistor 76 are identical, current $I_{66}$ is identical to the current conducted by transistor 76. $I_{66}$ is set according to the ratio of geometries between transistor 78 and 76 in low gain mode. A high gain condition is set when GAIN is at a logic high, rendering switch 81 in an open position and switch 79 in a closed position. Transistor 82 is rendered conductive, therefore, $I_{66}$ is a mirrored current generated by transistors 78 and 82 in relation to the ratio of geometries between transistors 78 and 82 to transistor 76. In other words, if the geometries of transistors 78, 82 and 76 are identical, current $I_{66}$ is identical to twice the amount of current conducted by transistor 76. $I_{66}$ is set according to relative geometries between transistors 78 and 82 to transistor 76 in high gain mode.

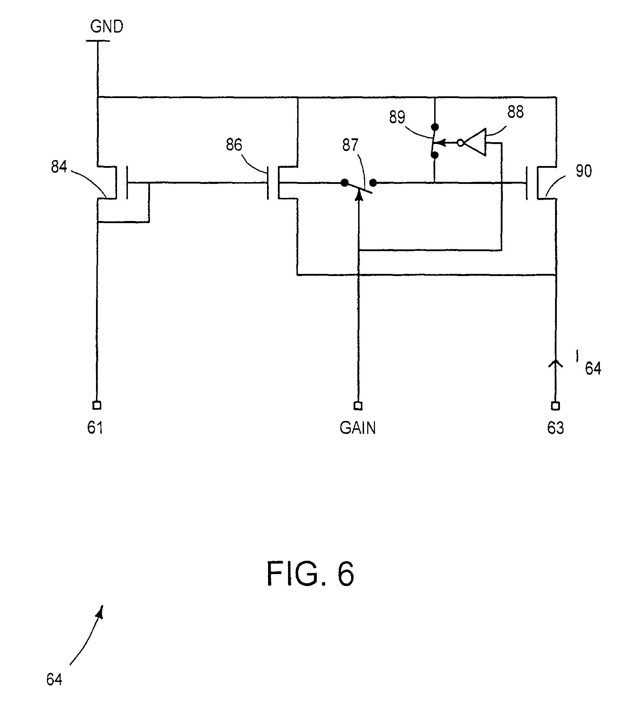

FIG. 6 illustrates a schematic diagram of NMOS current mirror 64. The gate terminals of NMOS transistors 84, 86 and a first conductor of switch 87 are coupled to a first conductor of transistor 84 at node 61. A second conductor of switch 87 is coupled to a first conductor of switch 89 and to the gate terminal of transistor 90. The GAIN node is coupled to the control terminal of switch 87 and the input to inverter 88. A first conductor of transistors 86 and 90 are coupled together at node 63 to create the output current, $I_{64}$, of NMOS current mirror 64.

In operation, NMOS current mirror 64 receives an input current at node 61 from transconductance amplifier 62. A low gain condition is set when GAIN is at a logic low, rendering switch 89 in a closed position and switch 87 in an open position. Transistor 90 is rendered non-conductive, therefore, $I_{54}$ is a mirrored current generated by transistor 86 in relation to the ratio of geometries between transistor 86 to transistor 84. In other words, if the geometries of transistor 84 and transistor 86 are identical, current $I_{64}$ is identical to the current conducted by transistor 84. $I_{64}$ is set according to the ratio of geometries between transistor 84 and 86 in low gain mode. A high gain condition is set when GAIN is at a logic high, rendering switch 89 in an open position and switch 87 in a closed position. Transistor 90 is rendered conductive, therefore, $I_{64}$ is a mirrored current generated by transistors 86 and 90 in relation to the ratio of geometries between transistors 86 and 90 to transistor 84. In other words, if the geometries of transistors 84, 86 and 90 are identical, current $I_{64}$ is identical to twice the amount of current conducted by transistor 84. $I_{64}$ is set according to relative geometries between transistors 86 and 90 to transistor 84 in high gain mode.

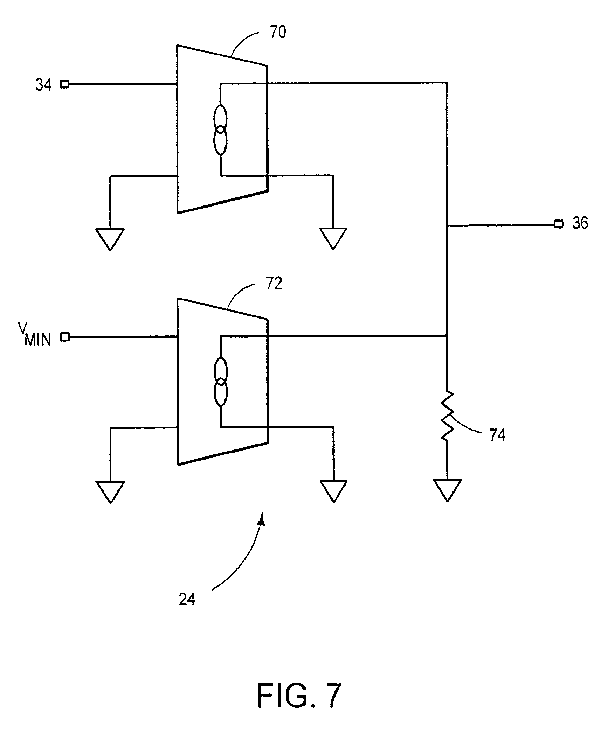

Minimum voltage adder 24 is illustrated in FIG. 7. Minimum voltage adder 24 receives the output of integrator 22 at node 34, which represents the error voltage of the control loop, as discussed earlier. Minimum voltage adder comprises transconductance amplifiers 70 and 72 along with resistor 74. Transconductance amplifier 70 receives the error voltage, $V_{errorr}$, at node 34 and converts the error voltage to a current, $I_{70}$, at node 36, where $I_{70} = V_{error}/R$. Transconductance amplifier 72 receives external control signal $V_{min}$ from TDMA communication device 12. The external control signal $V_{min}$ is then converted to a current by transconductance amplifier 72 and supplied to node 36. A first terminal of resistor 74 is coupled to terminal 36 and a second terminal of resistor 74 is coupled to the first power supply potential, for example, ground potential.

Control signal $V_{min}$, as discussed earlier, provides a minimum control voltage level to power amplifier 14, such that the output power level of power amplifier 14 is just below the maximum allowable power level during idle timeslots, $P_{IDLE}$. In operation, minimum voltage adder 24 receives the error voltage, $V_{error}$, and the external control voltage, $V_{min}$, and converts the error voltage and external control voltage to a current. The current signals are summed at node 36 and are subsequently converted back into voltage by the operation of resistor 74. The voltage at node 36 is characterized by

$$V_{36} = \left( \frac{1}{R} \sum V_1 \right) R_{74}$$ , where the summation of voltages, $V_1$, represents the summation of $V_{error}$ and $V_{min}$ and 1/R is the transconductance term of transconductance amplifiers 70 and 72. $R_{74}$ is the resistance value of resistor 74.

Due to the high output impedance of transconductance amplifiers 70 and 72, a buffer is required between minimum voltage adder 24 and the control input to power amplifier 14. Buffer 26 is therefore placed between the output of minimum voltage adder 24 and the control input of power amplifier 14, so that the current required by the control input of power amplifier 14 can be sourced by buffer 26. An input control terminal, ON/OFF, is provided by buffer 26. Terminal ON/OFF is controlled by TDMA communication device 12 in order to control the output power level of power amplifier 14. TDMA communication device 12 programs the ON/OFF terminal to the "on" state, thereby allowing buffer 26 to propagate the control voltage from minimum voltage adder 24 at node 36 to the control terminal of power amplifier 14 through node OUT. TDMA communication device 12 programs power amplifier 14 to the "off" state by activating the OFF control signal at terminal ON/OFF. Programming buffer 26 to the OFF state, prohibits the control voltage at node 36 to propagate to power amplifier 14, thereby reducing the output power level of power amplifier 14 to a minimum value.

By now it should be appreciated that a power amplifier driver circuit and a method for operating the power amplifier driver has been presented. Advantages of the power amplifier driver are realized by providing transconductance amplifiers to perform the integration and minimum voltage adder functions. Transconductance amplifiers provide higher bandwidth as compared to the operational amplifier counterparts, thereby allowing operation without employing low frequency poles to affect the overall stability of the control loop.

In particular there has been presented a power amplifier driver for a time division multiple access transmission device, the power amplifier driver providing a control signal in response to an error signal, the power amplifier driver comprising;

a detector having an input coupled to receive a first feedback signal representative of a transmission level and coupled to provide a detector signal operating in a first mode;

an error generator coupled to receive the detector signal and a first reference signal and coupled to provide a difference signal operating in a second mode to control the transmission level, the error generator characterized by:

a first conversion device coupled to receive a second reference signal and having an output wherein the error generator is configured to couple an output signal from the output of the first conversion device to a first node;

a second conversion device coupled to receive the detector signal and the first reference signal and also having an output configured to form an output signal to the first node; and

a gain control device having an input coupled to receive the output signal from the output of the second conversion device and an output coupled to provide a signal to the first node, a control input coupled to receive a gain control signal and coupled to provide the error signal, wherein the gain control device uses the gain control signal to modify a magnitude of the error signal.

Preferably, wherein the detector comprises:

a first detection stage having an input coupled to receive the signal representative of the transmission level, a power supply input coupled to receive a first supply potential and an output coupled to provide the detector signal; and

a second detection stage having a power supply input coupled to receive the first supply potential and an output coupled to provide the first reference signal.

Preferably, wherein the detector has first and second outputs and wherein the error generator is coupled to receive the first and second outputs of the power detector and coupled to convert the first feedback signal operating in the first mode to a second feedback signal operating in the second mode.

Preferably, wherein the first feedback signal in the first mode is indicative of a first power level and the second feedback signal in the second mode is indicative of a second power level; and

further including a third conversion circuit having a transconductance amplifier coupled to receive the second feedback signal and having a second transconductance amplifier coupled to receive a bias signal indicative of the second power level and coupled to provide the control signal indicative of the first and second power levels at an output of the power amplifier driver.

There has also been presented a method of forming an integrated circuit containing a power amplifier driver for receiving a feedback signal at a first pin and providing a control signal at a second pin to control a transmitted power level, the method comprising:

configuring an integrator with a first input coupled to receive a detection voltage indicative of a first level and coupled to form a difference signal, a second input coupled to receive a gain voltage and an output coupled to provide a transconductance error signal; and

coupling a summing device to receive the transconductance error signal and a bias signal and to provide the control signal in response to the transconductance error signal and the bias signal wherein the integrator is characterized by:

configuring a gain control device having a first input coupled to receive the difference signal and having a second input coupled to receive the gain voltage, the gain control device configured to adjust a magnitude of the transconductance error signal responsively to the gain voltage.

Preferably, further comprising:

coupling a conversion device to receive the detection voltage and having an output coupled to form the difference signal,

**Claims**

1. A power amplifier driver for a time division multiple access transmission device, the power amplifier driver providing a control signal in response to an error signal, the power amplifier driver comprising:

a detector (18) having an input coupled to receive a first feedback signal representative of a transmission level and coupled to provide a detector signal operating in a first mode; an error generator (22) coupled to receive the detector signal and a first reference signal (REF1) and coupled to provide a difference signal (61) operating in a second mode to control the transmission level, the error generator

**characterized by**:

a first conversion device (60) coupled to receive a second reference signal and having an output wherein the error generator is configured to couple an output signal from the output of the first conversion device to a first node; a second conversion device (62) coupled to receive the detector signal and the first reference signal and also having an output configured to form an output signal to the first node; and a gain control device (64) having an input coupled to receive the output signal from the output of the second conversion device (62) and an output coupled to provide a signal to the first node, a control input coupled to receive a gain control signal and coupled to provide the error signal, wherein the gain control device (64) uses the gain control signal to modify a magnitude of the error signal.

2. The power amplifier driver of claim 1, wherein the detector comprises:

a first detection stage (46, 54, 56) having an input coupled to receive the signal representative of the transmission level, a power supply input coupled to receive a first supply potential and an output coupled to provide the detector signal; and a second detection stage (44, 50, 52) having a power supply input coupled to receive the first supply potential and an output coupled to provide the first reference signal.

3. The power amplifier driver of either claim 1 or claim 2, wherein the detector (18) has first and second outputs and wherein the error generator (22) is coupled to receive the first and second outputs of the power detector and coupled to convert the first feedback signal operating in the first mode to a second feedback signal operating in the second mode.

4. The power amplifier driver of claim 3 wherein the first feedback signal in the first mode is indicative of a first power level and the second feedback signal in the second mode is indicative of a second power level; and further including a third conversion circuit (24) having a transconductance amplifier (70) coupled to receive the second feedback signal and having a second transconductance amplifier (72) coupled to receive a bias signal indicative of the second power level and coupled to provide the control signal indicative of the first and second power levels at an output of the power amplifier driver.

5. A method of forming an integrated circuit containing a power amplifier driver for receiving a feedback signal at a first pin and providing a control signal at a second pin to control a transmitted power level, the method comprising:

configuring an integrator (22) with a first input coupled to receive a detection voltage indicative of a first level and coupled to form a difference signal, a second input coupled to receive a gain voltage and an output coupled to provide a transconductance error signal; and coupling a summing device (24) to receive the transconductance error signal and a bias signal and to provide the control signal in response to the transconductance error signal and the bias signal wherein the integrator (22) is

**characterized by**:

configuring a gain control device (64) having a first input coupled to receive the difference signal and having a second input coupled to receive the gain voltage, the gain control device configured to adjust a magnitude of the transconductance error signal responsively to the gain voltage.

6. The method circuit of claim 5, further comprising:

coupling a conversion device (62) to receive the detection voltage and having an output coupled to form the difference signal.

**Patentansprüche**

1. Leistungsverstärkertreiber für eine Übertragungseinrichtung mit Zugriff über Zeitmultiplexverfahren, wobei der Leistungsverstärkertreiber ein Steuersignal bei einem Fehlersignal abgibt und der Leistungsverstärkertreiber Folgendes enthält:

einen Detektor (18), der einen Eingang aufweist, der so geschaltet ist, dass er ein erstes Rückkopplungssignal, das einem Übertragungspegel entspricht, empfängt, und ein Detektorsignal zur Verfügung stellt, das in einem ersten Betriebsmodus arbeitet,
einen Fehlergenerator (22), der so geschaltet ist, das er das Detektorsignal und ein erstes Referenzsignal (REF1) empfängt und ein Differenzsignal (61) zur Verfügung stellt, das in einem zweiten Modus arbeitet, um den Übertragungspegel zu steuern, wobei der Fehlergenerator **gekennzeichnet ist durch**
eine erste Umwandlungseinrichtung (60), die so geschaltet ist, dass sie ein zweites Referenzsignal empfängt und einen Ausgang aufweist, wobei der Fehlergenerator so konfiguriert ist, dass ein Ausgangssignal vom Ausgang des ersten Umwandlungsgerätes an einen ersten Knoten geschaltet wird,
eine zweite Umwandlungseinrichtung (62), die so geschaltet ist, dass sie das Detektorsignal und das erste Referenzsignal empfängt und außerdem einen Ausgang aufweist, der so konfiguriert ist, dass ein Ausgangssignal an dem ersten Knoten gebildet wird, und
eine Verstärkungssteuereinrichtung (64), die einen Eingang aufweist, der so geschaltet ist, dass er das Ausgangssignal vom Ausgang der zweiten Umwandlungseinrichtung (62) empfängt und ein Ausgang so geschaltet ist, dass er ein Signal an den ersten Knoten übermittelt, wobei ein Steuersignaleingang so geschaltet ist, dass er ein Verstärkungssteuersignal empfängt und so geschaltet ist, dass er ein Fehlersignal abgibt, wobei die Verstärkungssteuereinrichtung (64) das Verstärkungssteuersignal verwendet, um die Größe des Fehlersignals zu modifizieren.

2. Leistungsverstärkertreiber nach Anspruch 1, bei dem der Detektor Folgendes enthält:

eine erste Detektorstufe (46, 54, 56), die einen Eingang aufweist, der so geschaltet ist, dass er das Signal empfängt, das repräsentativ für den Übertragungspegel ist, einen Energiezufuhreingang, der so geschaltet ist, dass er ein erstes Zufuhrpotential empfängt und einen Ausgang aufweist, der so geschaltet ist, dass er das Detektorsignal zur Verfügung steht, und
eine zweite Detektorstufe (44, 50, 52), die einen Energiezufuhreingang aufweist, der so geschaltet ist, dass er das erste Zufuhrpotential empfängt und
einen Ausgang aufweist, der so geschaltet ist, dass er das erste Referenzsignal zur Verfügung stellt.

3. Leistungsverstärkertreiber nach Anspruch 1 oder 2, bei dem der Detektor (18) erste und zweite Ausgänge aufweist, und wobei der Fehlergenerator (22) so geschaltet ist, dass er die ersten und zweiten Ausgänge des Leistungsdetektors empfängt und so geschaltet ist, dass er das erste Rückkopplungssignal, das im ersten Modus arbeitet, in ein zweites Rückkopplungssignal umwandelt, das in dem zweiten Modus arbeitet.

4. Leistungsverstärkertreiber nach Anspruch 3, bei dem das ersten Rückkopplungssignal im ersten Modus einen ersten Leistungspegel anzeigt und das zweite Rückkopplungssignal im zweiten Modus einen zweiten Leistungspegel anzeigt und welcher ferner eine dritte Umwandlungsschaltung (24) enthält, die einen Transkonduktanzverstärker (70) enthält, der so geschaltet ist, dass er das zweite Rückkopplungssignal empfängt, und einen zweiten Transkonduktanzverstärker (72) aufweist, der so geschaltet ist, dass er ein Vorspannungssignal empfängt, das einen zweiten Leistungspegel anzeigt und so geschaltet ist, dass das zweite Steuersignal die ersten und zweiten Leistungspegel an einem Ausgang des Leistungsverstärkertreibers anzeigt.

5. Verfahren zur Bildung einer integrierten Schaltung, die einen Leistungsverstärkertreiber zur Aufnahme eines Rückkopplungssignals an einem ersten Anschluss enthält und ein Steuersignal an einem zweiten Anschluss zur Verfügung stellt, um einen gesendeten Leistungspegel zu steuern, wobei das Verfahren Folgendes enthält:

Konfigurierung eines Integrators (22) mit einem ersten Eingang, der so geschaltet ist, dass er eine Detektorspannung empfängt, die einen ersten Pegel anzeigt und so geschaltet ist, dass ein Differenzsignal gebildet wird, einen zweiten Eingang, der so geschaltet ist, dass er eine Verstärkungsspannung aufnimmt und ein Ausgang so geschaltet ist, dass er ein Transkonduktanzfehlersignal zur Verfügung stellt, und

Schaltung einer Summierungseinrichtung (24), um ein Transkonduktanzfehlersignal und ein Vorspannungssignal zu empfangen und das Steuersignal als Antwort auf das Transkonduktanzfehlersignal und das Vorspannungssignal zur Verfügung zu stellen, wobei der Integrator (22) **dadurch gekennzeichnet ist, dass**

eine Verstärkungssteuereinrichtung (64) konfiguriert wird, die einen ersten Ausgang aufweist, der so geschaltet ist, dass er das Differenzsignal empfängt und einen zweiten Ausgang aufweist, der so geschaltet ist, dass er das Verstärkungssignal empfängt, wobei die Verstärkungssteuereinrichtung so konfiguriert ist, dass die Größe des Transkonduktanzfehlersignals aufgrund der Verstärkungsspannung eingestellt wird.

**6.** Verfahrenschaltung nach Anspruch 5, welche ferner die Anschaltung eines Umwandlungsgerätes (62) enthält, um die Prüfspannung zu empfangen, und welche einen Ausgang enthält, der so geschaltet ist, dass er das Differenzsignal bildet.

## Revendications

**1.** Dispositif d'attaque d'un amplificateur de puissance destiné à un dispositif de transmission en mode accès multiple par répartition dans le temps, le dispositif d'attaque d'un amplificateur de puissance fournissant un signal de commande en réponse à un signal d'erreur, le dispositif d'attaque d'un amplificateur de puissance comprenant :

un détecteur (18) qui présente une entrée couplée de manière à recevoir un premier signal de rétroaction représentatif d'un niveau de transmission et couplée de manière à fournir un signal de détecteur qui fonctionne dans un premier mode ;

un générateur d'erreur (22) couplé de manière à recevoir le signal de détecteur et un premier signal de référence (REF1) et couplé de manière à fournir un signal de différence (61) qui fonctionne dans un deuxième mode de façon à commander le niveau de transmission, le générateur d'erreur étant **caractérisé par** :

un premier dispositif de conversion (60) couplé de manière à recevoir un deuxième signal de référence et qui présente une sortie, dans lequel le générateur d'erreur est configuré de manière à coupler un signal de sortie en provenance de la sortie du premier dispositif de conversion à un premier noeud;

un deuxième dispositif de conversion (62) couplé de manière à recevoir le signal de détecteur et le premier signal de référence et qui présente également une sortie configurée de manière à former un signal de sortie vers le premier noeud; et

un dispositif de commande de gain (64) qui présente une entrée couplée de manière à recevoir le signal de sortie en provenance de la sortie du deuxième dispositif de conversion (62) et une sortie couplée de manière à fournir un signal au premier noeud, une entrée de commande couplée de manière à recevoir un signal de commande de gain et couplée de manière à fournir le signal d'erreur, dans lequel le dispositif de commande de gain (64) utilise le signal de commande de gain de façon à modifier l'amplitude du signal d'erreur.

**2.** Dispositif d'attaque d'un amplificateur de puissance selon la revendication 1, dans lequel le détecteur comprend :

un premier étage de détection (46, 54, 56) qui présente une entrée couplée de manière à recevoir le signal représentatif du niveau de transmission, une entrée d'alimentation couplée de manière à recevoir un premier potentiel d'alimentation et une sortie couplée de manière à fournir le signal de détecteur ; et

un deuxième étage de détection (44, 50, 52) qui présente une entrée d'alimentation couplée de manière à recevoir le premier potentiel d'alimentation et une sortie couplée de manière à fournir le premier signal de référence.

**3.** Dispositif d'attaque d'un amplificateur de puissance selon la revendication 1 ou la revendication 2, dans lequel le détecteur (18) présente des première et deuxième sorties et dans lequel le générateur d'erreur (22) est couplé de manière à recevoir les première et deuxième sorties du détecteur de puissance et couplé de manière à convertir le premier signal de rétroaction qui fonctionne dans le premier mode en un deuxième signal de rétroaction qui fonctionne dans le deuxième mode.

**4.** Dispositif d'attaque d'un amplificateur de puissance selon la revendication 3, dans lequel le premier signal de rétroaction dans le premier mode est indicatif d'un premier niveau de puissance et le deuxième signal de rétroaction dans le deuxième mode est indicatif d'un deuxième niveau de puissance ; et comprenant en outre un troisième circuit de conversion (24) qui présente un amplificateur de transconductance (70) couplé de manière à recevoir le deuxième signal de rétroaction et qui présente un deuxième amplificateur de transconductance (72) couplé de manière à recevoir un signal de polarisation indicatif du deuxième niveau de puissance et couplé de manière à fournir le signal de commande indicatif des premier et deuxième niveaux de puissance au niveau d'une sortie du dispositif d'attaque d'un amplificateur de puissance.

5. Procédé de formation d'un circuit intégré qui contient un dispositif d'attaque d'un amplificateur de puissance destiné à recevoir un signal de rétroaction au niveau d'une première broche et à fournir un signal de commande au niveau d'une deuxième broche de façon à commander un niveau de puissance émise, le procédé comprenant les étapes consistant à :

configurer un intégrateur (22) avec une première entrée couplée de manière à recevoir une tension de détection indicative d'un premier niveau et couplée de manière à former un signal de différence, une deuxième entrée couplée de manière à recevoir une tension de gain et une sortie couplée de manière à fournir un signal d'erreur de transconductance ; et
coupler un dispositif de sommation (24) de manière à recevoir le signal d'erreur de transconductance et un signal de polarisation et à fournir le signal de commande en réponse au signal d'erreur de transconductance et au signal de polarisation, dans lequel l'intégrateur (22) est **caractérisé par** l'étape consistant à :

configurer un dispositif de commande de gain (64) qui présente une première entrée couplée de manière à recevoir le signal de différence et qui présente une deuxième entrée couplée de manière recevoir la tension de gain, le dispositif de commande de gain étant configuré de façon à régler l'amplitude du signal d'erreur de transconductance en réponse à la tension de gain.

6. Circuit de procédé selon la revendication 5, comprenant en outre :

le couplage d'un dispositif de conversion (62) de manière à recevoir la tension de détection et présentant une sortie couplée de manière à former le signal de différence.

FIG. 1

EP 1 239 603 B1

FIG. 2

FIG. 3

FIG. 4

EP 1 239 603 B1

V_dd

76
78
79
81
80
82

65
GAIN
I 66
67

FIG. 5

66

GND

84

86

87

89

88

90

61

GAIN

63

64

I 64

# FIG. 6

64

FIG. 7

**EP 1 239 603 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5150075 A
- US 5448770 A